# EUROPÄISCHE PATENTSCHRIFT

(11) **EP 0 739 158 B1**
(45) Veröffentlichungstag und Bekanntmachung des Hinweises auf die Patenterteilung: **10.03.1999**
(21) Anmeldenummer: 96105958.1
(22) Anmeldetag: 16.04.1996
(51) Int. Cl.: H05K 7/18, H05K 5/00, H02B 1/32

(54) **Vorrichtung zur Befestigung eines Anschlussmoduls an einem Träger sowie Schrank mit einer derartigen Vorrichtung**
Device for fastening a connection module to a support and cabinet with said device
Dispositif pour fixer un module de connexion sur un support et armoire avec ledit dispositif

(30) Priorität: 19.04.1995 DE 29506631 U
(43) Veröffentlichungstag der Anmeldung: 23.10.1996
(73) Patentinhaber: SIEMENS AKTIENGESELLSCHAFT, 80333 München (DE)
(72) Erfinder: Roster, Thomas, 76275 Ettlingen (DE); Schmitt, Reinhard, 76829 Landau (DE)

(56) Entgegenhaltungen:
- DE-A- 3 209 205
- DE-A- 3 409 022
- DE-A- 3 704 128
- DE-U- 9 311 526
- FR-A- 2 579 138
- FR-A- 2 580 869
- US-A- 5 095 403
- US-A- 5 287 428

## Beschreibung

Die Erfindung betrifft eine Vorrichtung zur Befestigung eines quaderförmigen Anschlußmoduls an einem Träger nach dem Oberbegriff des Anspruchs 1 sowie einen Schrank mit einer derartigen Vorrichtung nach dem Oberbegriff des Anspruchs 6. Die Unteransprüche betreffen vorteilhafte Weiterbildungen.

In der DE-U-93 11 526 ist ein Schrankgestell eines Automatisierungssystems beschrieben, welches aus Längs- und Querholmen besteht. In das Gestell sind Baugruppenträger eingebaut, die mit Baugruppen, z. B. digitalen Ein- und Ausgabebaugruppen, bestückt sind.

In derartigen Schränken müssen Signalleitungen, die von der Prozeßperipherie kommen, mit der Auswertungselektronik, die sich in den Baugruppenträgern befindet, verbunden werden. Neben einer reinrassigen Bestückung dieser Schränke mit nur einer Gerätefamilie sind häufig auch Schränke mit gemischter Bestückung unterschiedlicher Gerätefamilien erforderlich. Unterschiedliche Gerätefamilien erfordern auch eine unterschiedliche Anschlußtechnik für die Prozeßperipherie. Periphere Leitungen können somit nicht direkt auf die Anschlußstellen der Baugruppenträger aufgelegt werden, da die Leitungen häufig nicht der erforderlichen Anschlußtechnik entsprechen. Sie werden also zunächst auf zusätzliche Anschlußelemente geführt, die wiederum selbst durch geeignete Leitungen mit den Anschlußstellen der Auswertungselektronik verbunden sind. Als Anschlußelemente sind beispielsweise Reihenklemmen geeignet, die von verschiedenen Herstellern angeboten werden. Diese Reihenklemmen benötigen zur Montage ein Standardprofil, das auch als Hutschiene bezeichnet wird. Nachteilig bei diesen Reihenklemmen ist ihr großer Raumbedarf, da sie zusätzlich im Innenraum des Schranks untergebracht werden müssen. Weiterhin ist die Verwendung einer Hutschiene als Montageträger der Reihenklemmen von Nachteil, da aufgrund der unterschiedlichen Bestückungsvarianten der Schränke eine Vielzahl von Längenvarianten der Hutschiene erforderlich wären. Dies würde die Disposition und Lagerhaltung erheblich erschweren und somit das Automatisierungssystem verteuern.

Der Erfindung liegt die Aufgabe zugrunde, eine Vorrichtung zur Befestigung eines quaderförmigen Anschlußmoduls an einen Träger zu schaffen, die es ermöglicht, mit geringem Montageaufwand Anschlußmodule auf engem Raum, beispielsweise in einem Schrank eines Automatisierungssystems, unterzubringen. Eine weitere Aufgabe ist es, einen Schrank mit einer derartigen Vorrichtung auszurüsten.

Die Erfindung hat den Vorteil, daß quaderförmige Anschlußmodule ohne zusätzliches Werkzeug schnell in Schränken montierbar sind. Die Montage kann auch nachträglich erfolgen. Die quaderförmigen Anschlußmodule sind modular aneinanderreihbar und können mit einer durchgängigen Beschriftung versehen werden. Mit den Anschlußmodulen kann flexibel und modular auf die unterschiedlichen Anschlußtechniken der verschiedenen Gerätefamilien reagiert werden. Dabei ist die erfindungsgemäße Vorrichtung mit geringem Zusatzaufwand in die bekannte Aufbautechnik integrierbar. Bei einer Bestückung der quaderförmigen Anschlußmodule mit Schraub- oder Federkraftklemmen können Leitungen mit einem Anschlußquerschnitt von 0,5 mm² bis 2,5 mm² eingelegt werden. Pro Volumeneinheit werden sehr viele Anschlußpunkte möglich. Dabei sind Aufwand und Kosten je Anschlußelement gegenüber Reihenklemmen mit Hutschienen gering. Die Verdrahtung von Ein- und Ausgangsseite des quaderförmigen Anschlußmoduls ist übersichtlich, frei zugänglich und gut handhabbar.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen:
Figur 1 - an einem Träger befestigte Anschlußmodule,
Figuren 1A und 1B - Ausschnitte aus Figur 1,
Figur 2 ein geöffnetes quaderförmiges Anschlußmodul und
Figur 3 eine Rückansicht eines zusammengebauten Anschlußmoduls.

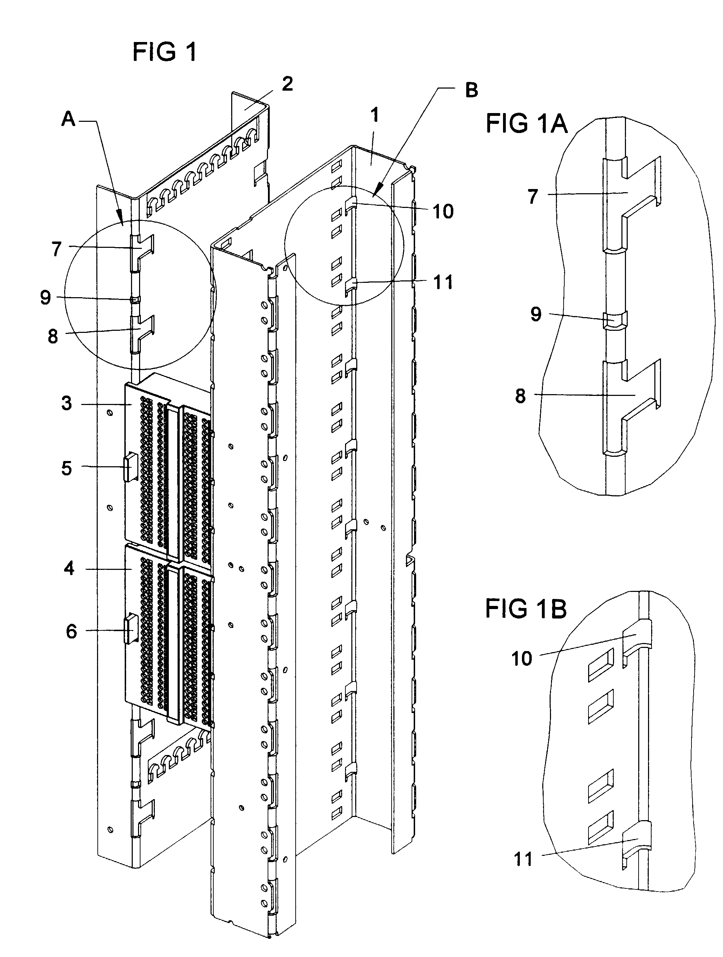

In Figur 1 sind zwei Längsholme 1 und 2 dargestellt, die in einem Schrank eines Automatisierungssystems senkrecht eingebaut werden können. Der Längsholm 1 dient auch zur Aufnahme von Baugruppenträgern. Die beiden Längsholme 1 und 2 sind mit ihren flachen Seiten parallel zueinander angeordnet. Dazwischen sind zwei quaderförmige Anschlußmodule 3 und 4 eingebaut. Das quaderförmige Anschlußmodul 3 ist mit einem Verriegelungshebel 5, das Anschlußmodul 4 mit einem Verriegelungshebel 6 versehen. Diese Verriegelungshebel 5 und 6 weisen in Figur 1 nicht sichtbare Rastnasen auf, die in Perforationen des Längsholms 2 eingerastet sind und die Lage der Anschlußmodule 3 und 4 fixieren. Oberhalb des Anschlußmoduls 3 sowie unterhalb des Anschlußmoduls 4 befindet sich jeweils ein Einbauplatz für ein weiteres Anschlußmodul. An dem freien Einbauplatz oberhalb des Anschlußmoduls 3 sind im Ausschnitt A die zum Einbau eines Anschlußmoduls vorgesehenen Perforationen im Längsholm 2 gut sichtbar. Für an der Rückseite eines Anschlußmoduls befindliche, nach außen ragende, senkrechte Laschen sind Perforationen 7 und 8 vorgesehen, die L-förmig ausgebildet und derart angeordnet sind, daß der erste Schenkel nahezu rechtwinklig am Seitenrand beginnt und der zweite Schenkel parallel zum Seitenrand nach unten verläuft. Auf der gegenüberliegenden Seite des Längsholms 1 befinden sich dazu korrespondierende Perforationen für die Laschen der anderen Seite des Anschlußmoduls, die in Figur 1 verdeckt sind. Eine Perforation 9 ist für die Rastnase des Verriegelungshebels vorgesehen. In Figur 1A ist der Ausschnitt A mit den beschriebenen Perforationen 7, 8 und 9 noch einmal vergrößert dargestellt. Zum Einbau wird ein Anschlußmodul zuerst mit seinen an der rechten Seite befindlichen Laschen in die nicht sichtbaren Perforationen des Längsholms 1 eingelegt, dann mit seinen Seiten parallel zu den Seiten der Längsholme 1 und 2 ausgerichtet und parallel nach hinten und nach unten verschoben, bis er sich in seiner Endlage befindet. In der Endlage rastet selbständig die Rastnase des Verriegelungshebels, der durch Federkraft gegen den Längsholm 2 gedrückt wird, ein. Durch das Zusammenwirken der Laschen und der in Figur 1 nicht sichtbaren Perforationen im Längsholm 1 sowie der Perforationen 7 und 8 im Längsholm 2 wird das Anschlußmodul in seiner Lage nach hinten, vorne und unten fixiert. Die Lagefixierung des Anschlußfeldes nach oben wird durch die Rastverbindung der Rastnase des Verriegelungshebels und der korrespondierenden Perforation 9 im Längsholm 2 erreicht. Weitere Einbauplätze für quaderförmige Schrankanschlußmodule befinden sich im rückseitigen Zwischenraum zwischen den beiden Längsholmen 1 und 2. Anschlußmodule können dort so eingebaut werden, daß ihre Anschlußelemente von der Rückseite aus zugänglich sind und sich der Verriegelungshebel von der Rückseite aus gesehen auf der rechten Seite befindet. Die zum Einbau erforderlichen Perforationen 10 und 11 für die Laschen auf der linken Seite eines Anschlußmoduls, die sich im Ausschnitt B befinden, sind in der Detailzeichnung Figur 1B vergrößert dargestellt.

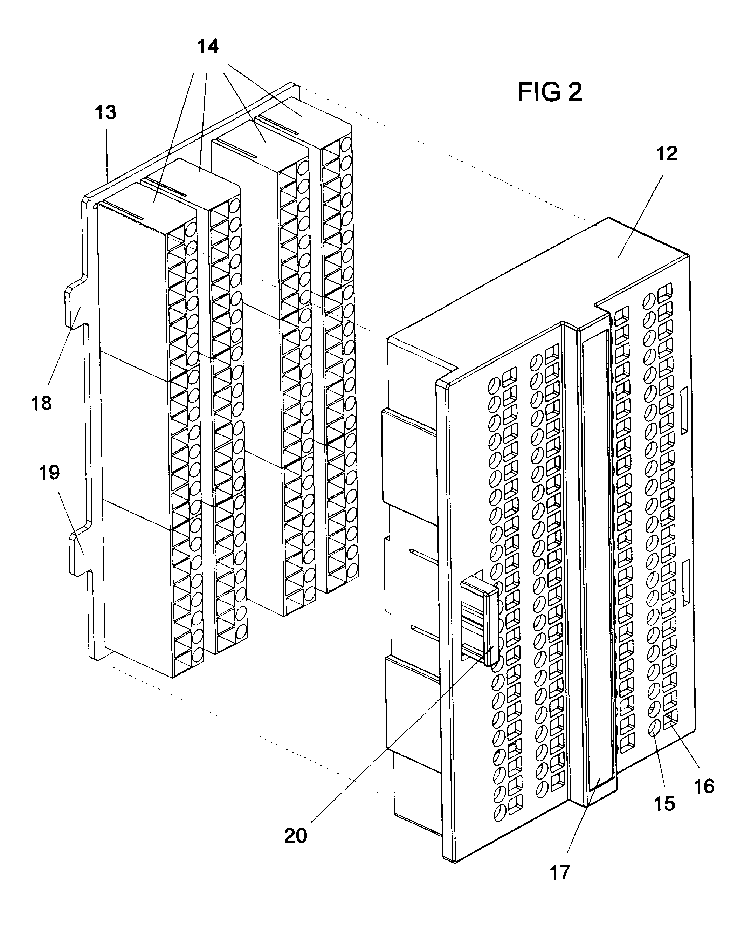

Ein quaderförmiges Anschlußmodul besteht nach Figur 2 im wesentlichen aus einem Gehäuse 12 und einer Leiterplatte 13, die mit Schraub- oder Federkraftklemmen 14 bestückt ist. Diese sind in 24 Zeilen mit je vier Klemmen pro Zeile angeordnet. Der Teilungsabstand von Zeile zu Zeile beträgt 5,08 mm. Die äußeren sowie die inneren beiden Klemmen sind je mit einer Leiterbahn auf der Leiterplatte 13 elektrisch verbunden. Damit ergeben sich 48 Durchgänge je Anschlußmodul. Die bestückte Leiterplatte 13 wird in das Kunststoffgehäuse 12 eingelegt und dort durch eine in Figur 2 nicht sichtbare Rastverbindung gehalten. Das Kunststoffgehäuse 12 hat im Bereich jeder Klemme eine Öffnung 15 zum Anlegen einer Leitung und eine Öffnung 16 für ein Betätigungswerkzeug. Eine mittige Erhöhung 17 des Kunststoffgehäuses 12 dient als Aufnahme für einen Kennzeichnungsstreifen der Anschlußzeile. Die Leiterplatte 13 besitzt auf der rechten und linken Seite je zwei Befestigungslaschen, die im eingebauten Zustand über das Kunststoffgehäuse 12 hinausragen. In Figur 2 sind lediglich die beiden Laschen 18 und 19 sichtbar. Ein Verriegelungshebel 20 ist federnd am Kunststoffgehäuse 12 aufgehängt und ragt über dessen Frontseite heraus. Der Ausbau des Anschlußmoduls kann vorteilhaft mit einer Hand erfolgen, indem der Daumen den Verriegelungshebel 20 bedient und die restlichen Finger hinter die mittige Erhöhung 17 des Kunststoffgehäuses 12 greifen. Nachdem die Rastverbindung entriegelt ist, wird das Anschlußmodul nach oben angehoben und nach vorne herausgezogen.

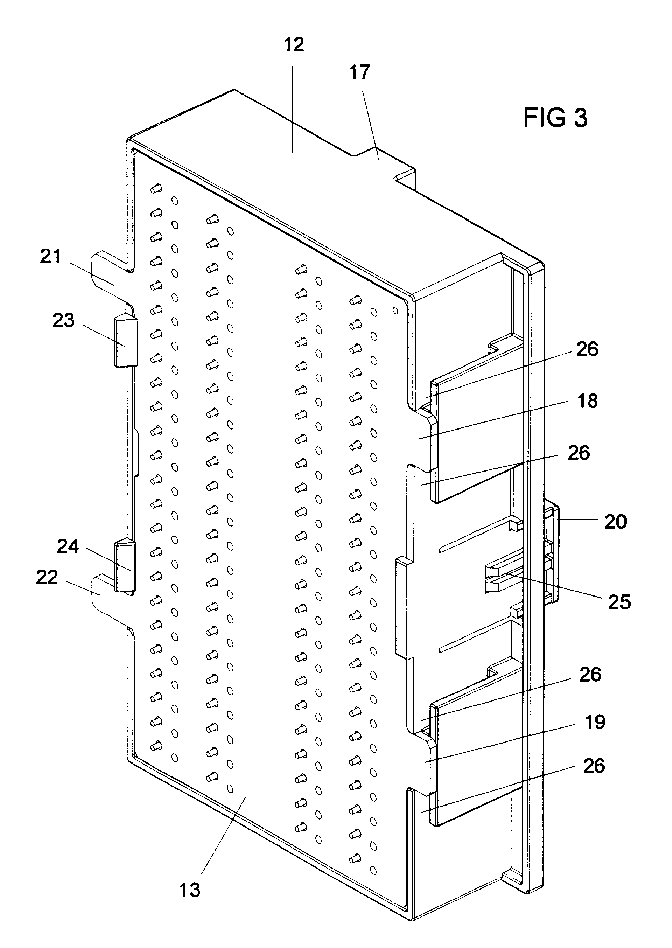

In der Rückansicht des Anschlußmoduls nach Figur 3 sind auch die Befestigungslaschen 21 und 22 sichtbar, die sich von der Vorderseite aus gesehen auf der rechten Seite des Anschlußmoduls befinden. Daneben sind Rastnasen 23 und 24 angeordnet, welche die Leiterplatte 13 im Gehäuse 12 fixieren. Bereits in Figur 2 eingeführte Bezugszeichen werden für gleiche Teile auch in Figur 3 verwendet. Eine Rastnase 25 des Verriegelungshebels 20 rastet beim Einbau des quaderförmigen Anschlußmoduls in die Öffnung 9 des Längsholms 2 (Figur 1, 1A) ein und verriegelt das Anschlußmodul. Führungsnuten 26 am Kunststoffgehäuse 12 sorgen für paralleles Verschieben des Anschlußmoduls entlang der Seiten der Längsholme 1 und 2, für eine eindeutige Lagefixierung des Anschlußmoduls an dem Längsholm 2 und für eine sichere Funktion der Rastverbindung des Verriegelungshebels 20. Durch die Führungsnuten 26 sind zudem größere Abstandstoleranzen zwischen den Längsholmen 1 und 2 leicht beherrschbar.

## Patentansprüche

1. Vorrichtung zur Befestigung eines quaderförmigen Anschlußmoduls (3, 4) an einem Träger (1, 2), **gekennzeichnet durch**
- einen Träger (1, 2) mit zumindest zwei flachen, parallel derart zueinander angeordneten Seiten, daß dazwischen das Anschußmodul eingebaut werden kann, wobei die Seiten mit ersten, zumindest auf einer Seite am Seitenrand beginnenden Ausnehmungen (7, 8) und zumindest einer zweiten Ausnehmung (9) versehen sind,
- feste Vorsprünge (18, 19, 21, 22) an zwei gegenüberliegenden Seitenflächen des Moduls, die derart ausgebildet und angeordnet sind, daß sie durch eine Verschiebung des Moduls in mindestens eine Richtung zwischen den beiden Seiten des Trägers (1, 2) in die ersten Ausnehmungen (7, 8) bis zu einer Endlage einfügbar sind, und
- zumindest ein Verriegelungselement (20, 25), das im wesentlichen senkrecht zu der mindestens einen Verschieberichtung des Moduls bewegbar und in die zweite Ausnehmung (9) derart einfügbar ist, daß es eine Bewegung des Moduls aus der Endlage heraus verhindert.

2. Vorrichtung nach Anspruch 1, **dadurch gekennzeichnet,** daß das Verriegelungselement als Federzunge mit einer Rastnase (25) ausgebildet ist, die mit der zweiten Ausnehmung (9) eine Rastverbindung herstellt.

3. Vorrichtung nach Anspruch 1 oder 2, **dadurch gekennzeichnet,** daß die ersten Ausnehmungen (7, 8) in den Seiten L-förmig und derart angeordnet sind, daß der erste Schenkel nahezu rechtwinklig am Seitenrand beginnt und der zweite Schenkel, dessen Ende die Endlage bestimmt, etwa parallel zum Seitenrand nach unten verläuft.

4. Vorrichtung nach einem der vorhergehenden Ansprüche, **dadurch gekennzeichnet,** daß die beiden Seiten des Trägers (1, 2) durch Blechschienen gebildet werden, in denen die Ausnehmungen (7 ... 11) als Durchbrechungen ausgeführt sind.

5. Vorrichtung nach Anspruch 4, **dadurch gekennzeichnet,** daß das Modul mit einer überstehenden, parallel zu einer Seitenfläche verlaufenden Lasche versehen ist, die beim Einfügen eine Blechschiene (2) hintergreift.

6. Schrank mit einem Gestell zur Aufnahme von Baugruppenträgern, das Längsholme (1) und Querholme aufweist, und mit einer Vorrichtung nach einem der vorhergehenden Ansprüche, **dadurch gekennzeichnet,** daß
- die den Baugruppenträgern abgewandte Seite eines Längsholms (1) eine Seite des Trägers ist und
- ein weiterer Längsholm (2) vorhanden ist, der die zweite Seite des Trägers aufweist.

7. Schrank nach Anspruch 6, **dadurch gekennzeichnet,**
- daß das Modul (3, 4) an der Frontseite des Schranks befestigbar ist und eine Leiterplatte (13) aufweist, die mit Schraub- oder Federkraftklemmen (14) bestückt ist, die paarweise durch eine Leiterbahn auf der Leiterplatte (13) elektrisch miteinander verbunden sind,
- daß das Modul weiterhin ein quaderförmiges, einseitig offenes Gehäuse (12) aufweist, in das die Leiterplatte (13) derart eingelegt ist, daß sie die offene Seite des Gehäuses (12) verschließt und daß sich die Klemmen (14) im Inneren des Gehäuses (12) befinden, und
- daß die Leiterplatte (13) an zwei gegenüberliegenden Kanten mit je zwei Laschen (18, 19, 21, 22) über das Gehäuse (12) hinausragt, welche die festen Vorsprünge der Vorrichtung bilden.

## Claims

1. Device for fastening a cuboid connection module (3, 4) to a support (1, 2), characterised by
- a support (1, 2) having at least two flat sides which are arranged in parallel with each other in such a way that the connection module can be installed between them, with the sides being provided with first recesses (7, 8), which begin at least on one side on the side edge, and at least one second recess (9),
- fixed projections (18, 19, 21, 22) on two opposing side faces of the module, which projections are constructed and arranged in such a way that they can be inserted into the first recesses (7, 8) up to an end position by shifting the module in at least one direction between the two sides of the support (1, 2), and
- at least one interlocking element (20, 25), which can be moved substantially perpendicularly with respect to the at least one shifting direction of the module and can be inserted into the second recess (9) in such a way that it prevents a movement of the module out of the end position.

2. Device according to claim 1, characterised in that the interlocking element is constructed as a spring-loaded tongue having a snap-in nose (25) which produces a snap-in connection with the second recess (9).

3. Device according to claim 1 or 2,
characterised in that the first recesses (7, 8) in the sides are L-shaped and are arranged in such a way that the first leg starts substantially at right angles to the side edge and the second leg, the end of which determines the end position, extends downwards substantially in parallel with the side edge.

4. Device according to one of the preceding claims, characterised in that the two sides of the support (1, 2) are formed by sheet-metal rails, in which the recesses (7 ... 11) are constructed as openings.

5. Device according to claim 4, characterised in that the module is provided with a protruding clip which extends in parallel with a side face and grips behind a sheet-metal rail (2) upon insertion.

6. Cabinet having a frame for receiving mounting racks, which frame has longitudinal bars (1) and transverse bars, and having a device according to one of the preceding claims, characterised
- in that the side of a longitudinal bar (1) that faces away from the mounting racks is one side of the support; and
- in that there is a further longitudinal bar (2) which has the second side of the support.

7. Cabinet according to claim 6, characterised
- in that the module (3, 4) can be fastened to the front side of the cabinet and has a printed-circuit board (13) which is provided with screw terminals or spring terminals (14), which are electrically connected to each other in pairs by a strip conductor on the printed-circuit board (13),
- in that the module furthermore has a cuboid housing (12) which is open on one side and into which the printed-circuit board (13) can be inserted in such a way that it closes the open side of the housing (12) and the terminals (14) are located on the inside of the housing (12), and
- in that the printed-circuit board (13), on two opposing edges, protrudes over the housing (12) with two clips (18, 19, 21, 22) in each case, which clips form the fixed projections of the device.

## Revendications

1. Dispositif pour fixer un module (3, 4) de connexion parallélépipédique sur un support (1, 2), **caractérisé** par
- un support (1, 2), comportant au moins deux côtés plats, disposés en parallèlement de telle sorte que le module de connexion peut être inséré entre eux, ces côtés étant pourvus de premiers (7, 8) évidements commençant au moins sur un côté sur le bord du côté, et d'au moins un deuxième (9) évidement,
- des saillies (18, 19, 21, 22) fixes sur deux faces latérales opposées du module, qui sont conformées et disposées de telle sorte que, par un déplacement du module dans au moins une direction entre les deux côtés du support (1, 2), elles peuvent être insérées dans les premiers (7, 8) évidements jusqu'à une position finale, et
- au moins un élément (20, 25) de verrouillage, qui peut être déplacé essentiellement perpendiculairement à la ou les directions de déplacement du module et inséré dans le deuxième (9) évidement de telle sorte qu'il empêche le module de quitter la position finale.

2. Dispositif suivant la revendication 1, **caractérisé** en ce que l'élément de verrouillage est réalisé sous forme de languette élastique, pourvue d'un ergot (25) de crantage qui réalise un assemblage par encliquetage avec le deuxième (9) évidement.

3. Dispositif suivant la revendication 1 ou 2, **caractérisé** en ce que les premiers (7, 8) évidements des côtés sont en forme de L et disposés de telle sorte que la première branche commence quasiment à angle droit sur le bord du côté et la deuxième branche, dont l'extrémité définit la position finale, s'étend vers le bas environ parallèlement au bord du côté.

4. Dispositif suivant l'une des revendications précédentes, **caractérisé** en ce que les deux côtés du support (1, 2) sont formés par des profilés en tôle, dans lesquels les évidements (7 .... 11) sont réalisés sous la forme de découpures.

5. Dispositif suivant la revendication 4, **caractérisé** en ce que le module est pourvu d'une patte qui dépasse, qui s'étend parallèlement à une face latérale et qui s'accroche derrière un profilé (2) en tôle lors de l'insertion.

6. Armoire comportant un bâti, destiné à recevoir des supports de sous-ensembles et comprenant des montants (1) longitudinaux et des traverses, et comportant un dispositif suivant l'une des revendications précédentes, **caractérisée** en ce que
- le côté d'un montant (1) longitudinal qui est opposé aux supports de sous-ensembles est un côté du support, et
- un autre montant (2) longitudinal est présent et forme le deuxième côté du support.

7. Armoire suivant la revendication 1, **caractérisée**
- en ce que le module (3, 4) peut être fixé sur le côté frontal de l'armoire et comporte une plaquette (13) à circuits imprimés, qui est équipée de bornes (14) à vis ou à ressort qui sont électriquement reliées entre elles par paires par une piste conductrice sur la plaquette (13) à circuits imprimés,
- en ce que le module comporte en outre un boîtier (12) parallélépipédique, ouvert d'un côté, dans lequel la plaquette (13) à circuits imprimés est insérée de telle sorte qu'elle ferme le côté ouvert du boîtier (12) et que les bornes (14) se trouvent à l'intérieur du boîtier (12),
- et en ce que la plaquette (13) à circuits imprimés dépasse, sur deux bords opposés, du boîtier (12) par deux pattes (18, 19, 21, 22) respectives, qui forment les saillies fixes du dispositif.
